# EUROPEAN PATENT APPLICATION

(11) **EP 4 521 448 A1**
(43) Date of publication of application: **12.03.2025**
(21) Application number: 23799504.8
(22) Date of filing: 02.05.2023
(51) Int. Cl.: H01L 21/3065

(54) **PLASMA PROCESSING METHOD AND PLASMA PROCESSING DEVICE**

(30) Priority: 02.05.2022 JP 2022076087
(71) Applicant: Tokyo Electron Limited, Tokyo 107-6325 (JP)
(72) Inventor: TAKINO, Yusuke, Kurokawa-gun, Miyagi 981-3629 (JP); YONEZAWA, Takahiro, Kurokawa-gun, Miyagi 981-3629 (JP)
(74) Representative: FRKelly
(86) International application number: PCT/JP2023/017103
(87) International publication number: WO 2023/214575

(57) **Abstract**

To provide technique capable of reducing defects in plasma processing. A plasma processing method according to the present disclosure includes a preparation step of preparing a substrate having a first etching film and a mask on the first etching film, the mask including a metal-containing film; and a first etching step of generating plasma in a chamber with a processing gas including one or both of a chlorine-containing gas and a bromine-containing gas to etch the first etching film.

## Description

### Background

### Field

Exemplary embodiments of the present disclosure relate to a plasma processing method and a plasma processing apparatus.

### Description of Related Art

Japanese Patent Application Laid-Open No. 2018-6742 discloses a technique of using a thin tin oxide film as a spacer in a pattern forming method in manufacturing a semiconductor device.

### Summary

The present disclosure provides a technique capable of reducing defects in plasma processing.

In one exemplary embodiment of the present disclosure, a plasma processing method is provided. The plasma processing method includes a preparation step of preparing a substrate having a first etching film and a mask on the first etching film in a chamber, in which the mask includes a metal-containing film; and a first etching step of generating plasma in the chamber with a processing gas including one or both of a chlorine-containing gas and a bromine-containing gas to etch the first etching film.

According to one exemplary embodiment of the present disclosure, it is possible to provide a technique capable of reducing defects in plasma processing.

### Brief Description of Drawings

Fig. 1 is a diagram for describing a configuration example of an inductively coupled plasma processing apparatus.
Fig. 2 is a flowchart illustrating a plasma processing method according to one exemplary embodiment.
Fig. 3 is a view illustrating an example of a cross-sectional structure of a substrate W.
Fig. 4 is a view illustrating an example of a cross-sectional structure of a substrate W.
Fig. 5 is a view illustrating an example of a cross-sectional structure of a substrate W.

### Detailed Description

Hereinafter, each embodiment of the present disclosure will be described.

In one exemplary embodiment, a plasma processing method is provided. In one exemplary embodiment, a plasma processing method is provided. The plasma processing method includes a preparation step of preparing a substrate having a first etching film and a mask on the first etching film in a chamber, the mask including a metal-containing film; and a first etching step of generating plasma in the chamber with a processing gas including one or both of a chlorine-containing gas and a bromine-containing gas to etch the first etching film.

In one exemplary embodiment, a metal-containing film contains tin (Sn).

In one exemplary embodiment, a first etching film is a silicon (Si)-containing film, a metal-containing film, or an organic film.

In one exemplary embodiment, the first etching film is a silicon-containing film in which a ratio of the number of silicon atoms to the number of atoms other than silicon in the silicon-containing film is larger than a ratio of the number of silicon atoms to the number of atoms other than silicon in silicon oxide.

In one exemplary embodiment, the first etching film includes at least one silicon-containing film selected from the group consisting of silicon carbide, amorphous silicon, and a silicon-containing antireflection film.

In one exemplary embodiment, the chlorine-containing gas and the bromine-containing gas do not contain hydrogen nor fluorine.

In one exemplary embodiment, the chlorine-containing gas contains carbon.

In one exemplary embodiment, the first etching film includes a silicon oxide film.

In one exemplary embodiment, the processing gas includes a chlorine-containing gas, and the chlorine-containing gas includes at least one selected from the group consisting of Cl₂, CₓCl_{y} (x and y are an integer of 1 or more), and SiⱼClₖ (j and k are an integer of 1 or more).

In one exemplary embodiment, the processing gas includes an inert gas.

In one exemplary embodiment, the inert gas includes nitrogen gas (N₂) or helium gas (He).

In one exemplary embodiment, the substrate includes a second etching film and the first etching film is disposed on the second etching film, and the plasma processing method further includes a second etching step of etching the second etching film using at least the first etching film as a mask after the first etching step.

In one exemplary embodiment, the processing gas does not include an oxygen-containing gas.

In one exemplary embodiment, the first etching step includes setting a pressure in the chamber to 100 mTorr or more.

In one exemplary embodiment, the preparation step includes disposing the substrate on a substrate support, the first etching step includes supplying a bias RF signal to the substrate support, an effective value of power of the bias RF signal being 100 W or more.

In one exemplary embodiment, the first etching step includes setting a pressure in the chamber to 100 mTorr or less.

In one exemplary embodiment, the first etching step includes supplying a bias RF signal to the substrate support, and an effective value of power of the bias RF signal is 200 W or less.

In one exemplary embodiment, a plasma processing method executed in a plasma processing apparatus having a chamber and a substrate support disposed in the chamber is provided. The plasma processing method includes a preparation step of preparing a substrate having a first etching film and a mask on the first etching film on the substrate support, the mask including a metal-containing film, and a first etching step of plasma-etching the first etching film under a condition that tin fluoride is not formed on a surface of the mask.

In one exemplary embodiment, a plasma processing apparatus including a chamber, a substrate support disposed in the chamber, and a controller is provided. In the plasma processing apparatus, the controller executes preparing a substrate having a first etching film and a mask on the first etching film on the substrate support, the mask including a metal-containing film, and generating plasma in the chamber with a processing gas including one or both of a chlorine-containing gas and a bromine-containing gas to etch the first etching film.

Hereinafter, each embodiment of the present disclosure will be described in detail with reference to the drawings. In each drawing, the same or similar elements will be given the same reference numerals, and repeated descriptions will be omitted. Unless otherwise specified, a positional relationship such as up, down, left, and right will be described based on a positional relationship illustrated in the drawings. A dimensional ratio in the drawings does not indicate an actual ratio, and the actual ratio is not limited to the ratio illustrated in the drawings.

### <Configuration example of plasma processing system>

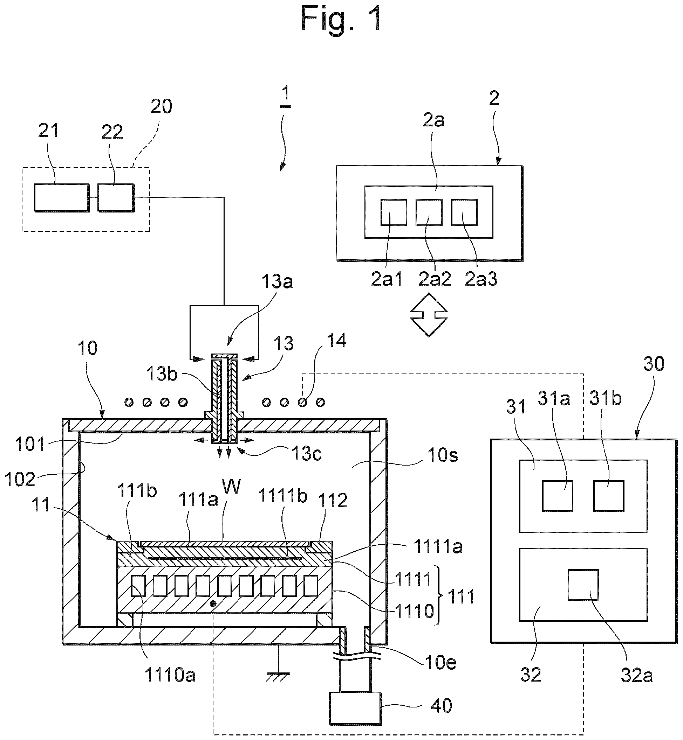

Hereinafter, a configuration example of a plasma processing system will be described. Fig. 1 is a diagram for describing the configuration example of an inductively coupled plasma processing apparatus.

The plasma processing system includes an inductively coupled plasma processing apparatus 1 and a controller 2. The inductively coupled plasma processing apparatus 1 includes a plasma processing chamber 10, a gas supply 20, a power supply 30, and an exhaust system 40. The plasma processing chamber 10 includes a dielectric window. In addition, the plasma processing apparatus 1 includes a substrate support 11, a gas introducer, and an antenna 14. The substrate support 11 is disposed in the plasma processing chamber 10. The antenna 14 is disposed on or above the plasma processing chamber 10 (that is, on or above the dielectric window 101). The plasma processing chamber 10 has a plasma processing space 10s defined by the dielectric window 101, a side wall 102 of the plasma processing chamber 10, and the substrate support 11. The plasma processing chamber 10 has at least one gas supply port for supplying at least one processing gas to the plasma processing space 10s, and at least one gas exhaust port for exhausting the gas from the plasma processing space. The plasma processing chamber 10 is grounded.

The substrate support 11 includes a main body 111 and a ring assembly 112. The main body 111 has a center region 111a for supporting the substrate W and an annular region 111b for supporting the ring assembly 112. A wafer is an example of the substrate W. The annular region 111b of the main body 111 surrounds the center region 111a of the main body 111 in a plan view. The substrate W is disposed on the center region 111a of the main body 111, and the ring assembly 112 is disposed on the annular region 111b of the main body 111 so as to surround the substrate W on the center region 111a of the main body 111. Therefore, the center region 111a is also referred to as a substrate support surface for supporting the substrate W, and the annular region 111b is also referred to as a ring support surface for supporting the ring assembly 112.

In one embodiment, the main body 111 includes a base 1110 and an electrostatic chuck 1111. The base 1110 includes a conductive member. The conductive member of the base 1110 may function as a bias electrode. The electrostatic chuck 1111 is disposed on the base 1110. The electrostatic chuck 1111 includes a ceramic member 1111a and an electrostatic electrode 1111b disposed in the ceramic member 1111a. The ceramic member 1111a has a center region 111a. In one embodiment, the ceramic member 1111a also has an annular region 111b. Another member that surrounds the electrostatic chuck 1111 may have the annular region 111b, such as an annular electrostatic chuck or an annular insulating member. In this case, the ring assembly 112 may be disposed on the annular electrostatic chuck or the annular insulating member, or may be disposed on both the electrostatic chuck 1111 and the annular insulating member. In addition, at least one RF/DC electrode coupled to a radio frequency (RF) power supply 31 and/or a direct current (DC) power supply 32, which will be described later, may be disposed in the ceramic member 1111a. In this case, at least one RF/DC electrode functions as the bias electrode. The conductive member of the base 1110 and at least one RF/DC electrode may function as a plurality of bias electrodes. Further, the electrostatic electrode 1111b may function as the bias electrode. Therefore, the substrate support 11 includes at least one bias electrode.

The ring assembly 112 includes one or a plurality of annular members. In one embodiment, one or the plurality of annular members includes one or a plurality of edge rings and at least one cover ring. The edge ring is formed of a conductive material or an insulating material, and the cover ring is formed of an insulating material.

In addition, the substrate support 11 may include a temperature-controlled module configured to adjust at least one of the electrostatic chuck 1111, the ring assembly 112, and the substrate to a target temperature. The temperature-controlled module may include a heater, a heat transfer medium, a flow path 1110a, or a combination thereof. A heat transfer fluid such as brine or a gas flows in the flow path 1110a. In one embodiment, the flow path 1110a is formed in the base 1110, and one or a plurality of heaters are disposed in the ceramic member 1111a of the electrostatic chuck 1111. Further, the substrate support 11 may include a heat transfer gas supply configured to supply the heat transfer gas to a gap between a back surface of the substrate W and the center region 111a.

The gas introducer is configured to introduce at least one processing gas from the gas supply 20 into the plasma processing space 10s. In one embodiment, the gas introducer includes a center gas injector (CGI) 13. The center gas injector 13 is disposed above the substrate support 11 and is attached to a center opening portion formed in the dielectric window 101. The center gas injector 13 has at least one gas supply port 13a, at least one gas flow path 13b, and at least one gas introduction port 13c. The processing gas supplied to the gas supply port 13a passes through the gas flow path 13b and is introduced into the plasma processing space 10s from the gas introduction port 13c. In addition, the gas introducer may include one or a plurality of side gas injectors (SGI) attached to one or a plurality of opening portions formed in the side wall 102 in addition to or instead of the center gas injector 13.

The gas supply 20 may include at least one gas source 21 and at least one flow rate controller 22. In one embodiment, the gas supply 20 is configured to supply at least one processing gas from the gas sources 21 each corresponding thereto to the gas introducer via the flow rate controllers 22 each corresponding thereto. Each flow rate controller 22 may include, for example, a mass flow controller or a pressure-controlled flow rate controller. Further, the gas supply 20 may include one or more flow rate modulation devices that modulate or pulse the flow rate of at least one processing gas.

The power supply 30 includes an RF power supply 31 coupled to the plasma processing chamber 10 via at least one impedance matching circuit. The RF power supply 31 is configured to supply at least one RF signal (RF power) to at least one bias electrode and the antenna 14. As a result, plasma is formed from at least one processing gas supplied to the plasma processing space 10s. Therefore, the RF power supply 31 may function as at least a part of the plasma generator configured to generate the plasma from one or more processing gases in the plasma processing chamber 10. Further, by supplying the bias RF signal to at least one bias electrode, the bias potential is generated on the substrate W, and ions in the formed plasma are able to be drawn into the substrate W.

In one embodiment, the RF power supply 31 includes a first RF generator 31a and a second RF generator 31b. The first RF generator 31a is coupled to the antenna 14 and is configured to generate the source RF signal (source RF power) for plasma generation via at least one impedance matching circuit. In one embodiment, the source RF signal has a frequency in a range of 10 MHz to 150 MHz. In one embodiment, the first RF generator 31a may be configured to generate a plurality of source RF signals having different frequencies. The generated one or the plurality of source RF signals are supplied to the antenna 14.

The second RF generator 31b is coupled to at least one bias electrode via at least one impedance matching circuit and is configured to generate the bias RF signal (bias RF power). The frequency of the bias RF signal may be the same as or different from the frequency of the source RF signal. In one embodiment, the bias RF signal has a frequency lower than the frequency of the source RF signal. In one embodiment, the bias RF signal has a frequency in a range of 100 kHz to 60 MHz. In one embodiment, the second RF generator 31b may be configured to generate a plurality of bias RF signals having different frequencies. The generated one or plurality of bias RF signals are supplied to at least one bias electrode. In addition, in various embodiments, at least one of the source RF signal and the bias RF signal may be pulsed.

In addition, the power supply 30 may include a DC power supply 32 coupled to the plasma processing chamber 10. The DC power supply 32 includes a bias DC generator 32a. In one embodiment, the bias DC generator 32a is connected to at least one bias electrode and is configured to generate the bias DC signal. The generated bias DC signal is applied to at least one bias electrode.

In various embodiments, the bias DC signal may be pulsed. In this case, a sequence of voltage pulses is applied to at least one bias electrode. The voltage pulse may have a pulse waveform of a rectangular shape, a trapezoidal shape, a triangular shape, or a combination thereof. In one embodiment, the waveform generator for generating the sequence of voltage pulses from the DC signal is connected between the bias DC generator 32a and at least one bias electrode. Therefore, the bias DC generator 32a and the waveform generator configure the voltage pulse generator. The voltage pulse may have a positive polarity or a negative polarity. In addition, the sequence of voltage pulses may include one or a plurality of positive voltage pulses and one or a plurality of negative voltage pulses in one cycle. The bias DC generator 32a may be provided in addition to the RF power supply 31 or may be provided instead of the second RF generator 31b.

The antenna 14 includes one or a plurality of coils. In one embodiment, the antenna 14 may include an outer coil and an inner coil disposed coaxially. In this case, the RF power supply 31 may be connected to both the outer coil and the inner coil, or may be connected to one of the outer coil and the inner coil. In the former case, the same RF generator may be connected to both the outer coil and the inner coil, or the RF generators may be connected to the outer coil and the inner coil separately.

The exhaust system 40 may be connected to, for example, a gas exhaust port 10e provided at a bottom portion of the plasma processing chamber 10. The exhaust system 40 may include a pressure control valve and a vacuum pump. A pressure in the plasma processing space 10s is controlled by the pressure control valve. The vacuum pump may include a turbomolecular pump, a dry pump, or a combination thereof.

The controller 2 processes a computer-executable instruction that causes the plasma processing apparatus 1 to execute various steps described in the present disclosure. The controller 2 may be configured to control each element of the plasma processing apparatus 1 to execute the various steps described here. In one embodiment, a part or the entirety of the controller 2 may be included in the plasma processing apparatus 1. The controller 2 may include a processor 2a1, a storage 2a2, and a communication interface 2a3. The controller 2 is realized by, for example, a computer 2a. The processor 2a1 may be configured to read out a program from the storage 2a2 and execute the read-out program to perform various control operations. This program may be stored in the storage 2a2 in advance, or may be acquired through a medium when necessary. The acquired program is stored in the storage 2a2 and is read out from the storage 2a2 and executed by the processor 2a1. The medium may be various storage media readable by the computer 2a, or may be a communication line connected to the communication interface 2a3. The processor 2a1 may be a central processing unit (CPU). The storage 2a2 may include a random access memory (RAM), a read only memory (ROM), a hard disk drive (HDD), a solid state drive (SSD), or a combination thereof. The communication interface 2a3 may communicate with the plasma processing apparatus 1 through a communication line such as a local area network (LAN).

### <Example of plasma processing method>

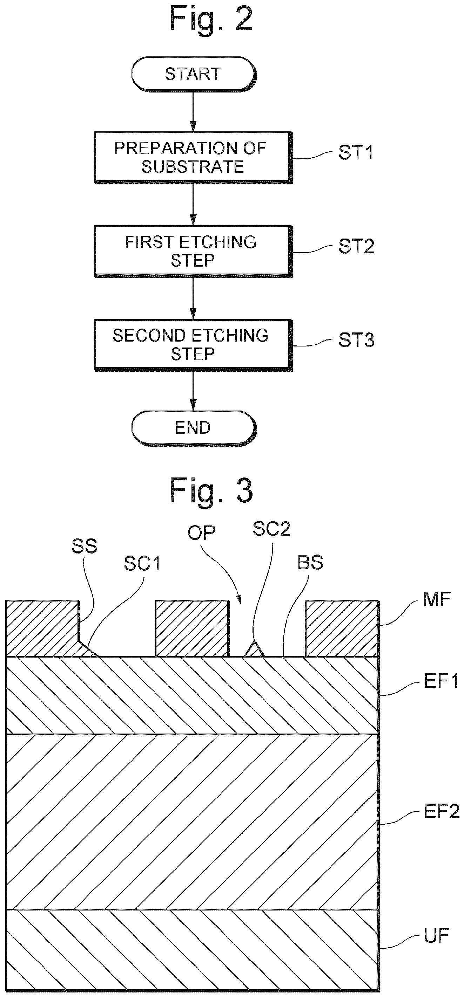

Fig. 2 is a flowchart illustrating a plasma processing method (hereinafter, also referred to as "the present processing method") according to one exemplary embodiment. As illustrated in Fig. 2, the present processing method includes a step ST1 of preparing a substrate, a first etching step ST2, and a second etching step ST3. The processing in each step may be executed by the plasma processing system illustrated in Fig. 1. A case where the controller 2 controls each unit of the plasma processing apparatus 1 to execute the present processing method on the substrate W will be described below as an example.

### (Step ST1: preparation of substrate)

In the step ST1, the substrate W is prepared in the plasma processing space 10s of the plasma processing apparatus 1. The substrate W is provided on the center region 111a of the substrate support 11. Then, the substrate W is held by the substrate support 11 by the electrostatic chuck 1111.

Fig. 3 is a view illustrating an example of a cross-sectional structure of the substrate W prepared in the step ST1. In the substrate W, an etching film EF2, an etching film EF1, and a metal-containing film MF are stacked on an underlying film UF in this order. The substrate W may be used for manufacturing semiconductor devices. The semiconductor device may include, for example, a semiconductor memory device such as DRAM or 3D-NAND flash memory.

The underlying film UF is, for example, a silicon wafer, an organic film, a dielectric film, a metal film, a semiconductor film, or the like formed on the silicon wafer. The underlying film UF may be configured by stacking a plurality of films.

The etching film EF2 is a film that is etched using the metal-containing film MF and/or the etching film EF1 as a mask. The etching film EF2 may include a carbon-containing film. In one example, the carbon-containing film may be a spin-on carbon (SOC) film or an amorphous carbon film. In addition, the etching film EF2 may be configured to include two or more stacked films. In a case where the etching film EF1 includes a carbon-containing film, the etching film EF2 may be a silicon-containing film, as will be described later. In one example, the silicon-containing film may be a silicon oxide film, a silicon nitride film, silicon carbide (SiC), amorphous silicon (a-Si), or a silicon-containing antireflection film (SiARC). The etching film EF2 is an example of a second etching film.

The etching film EF1 is a film that is etched using the metal-containing film MF as a mask. The etching film EF1 may include a metal-containing film different from the silicon-containing film or the metal-containing film MF. In one example, the silicon-containing film may include a film in which a ratio of the number of silicon atoms to the number of atoms other than silicon is larger than that of the number of silicon atoms to the number of atoms other than silicon in silicon oxide. The silicon-containing film may be, for example, silicon carbide (SiC), amorphous silicon (a-Si), or a silicon-containing antireflection film (SiARC). The etching film EF1 may or may not include the silicon oxide film. In one example, the metal-containing film may be a film composed of an oxide, a nitride, a silicate, or an oxynitride of Zr, Hf, Ta, Ti, Al, Y, La, W, Mo, Ni, Ru, or Co. In addition, the etching film EF1 may be configured to include two or more kinds of stacked films. The etching film EF1 is an example of the first etching film. The etching film EF1 may be a carbon-containing film. In one example, the carbon-containing film may be a spin-on carbon (SOC) film or an amorphous carbon film.

The metal-containing film MF is a film that functions as a mask in the etching of the etching film EF1. The metal-containing film MF may contain at least one selected from the group consisting of tin (Sn), hafnium (Hf), indium (In), titanium (Ti), and zirconium (Zr). The metal-containing film MF may contain tin. That is, the metal-containing film MF may be a tin-containing film. In one example, the metal-containing film MF may contain at least one of tin oxide or tin hydroxide. In addition, the metal-containing film MF may contain an organic substance. The metal-containing film MF is an example of a mask film.

The metal-containing film MF has at least one opening OP. The opening OP is defined by the side surface SS of the metal-containing film MF. The opening OP is a space on the etching film EF1 surrounded by the side surfaces SS. That is, in Fig. 3, the upper surface of the etching film EF1 has a portion covered with the metal-containing film MF and a portion exposed at the bottom portion BS of the opening OP.

The opening OP may have any shape in a plan view of the substrate W (in a case where the substrate W is viewed in a direction from the top to the bottom in Fig. 3). The shape may be, for example, a circle, an ellipse, a rectangle, a line, or a shape in which one or more of these are combined. The metal-containing film MF may have a plurality of openings OP. The plurality of openings OP may each have a hole shape and constitute an array pattern arranged at regular intervals. The plurality of openings OP may each have a linear shape and may be arranged at regular intervals to form a line & space pattern.

At least a part of the side surface SS of the metal-containing film MF may have a portion SC1 extending toward the opening OP. The portion SC1 may be present at the bottom portion BS of the opening OP. In addition, the portion SC1 may be a protruding portion that protrudes from the side surface SS toward the opening OP in a region of the side surface SS that is separated from the bottom portion BS upward. In addition, the metal-containing film MF may include a portion SC2 that is isolated at the bottom portion BS of the opening OP without being connected to the side surface SS of the metal-containing film MF. The portions SC1 and SC2 may be scum of the metal-containing film MF. The scum may be, for example, a residue of a resist that is not completely removed in a process (for example, a development process) of forming the opening OP in the metal-containing film MF.

The metal-containing film MF has a predetermined pattern including the opening OP. The opening OP may be formed by patterning by lithography. In one example, first, a photoresist film containing tin is formed on the etching film EF1. Then, the photoresist film is selectively irradiated with light (for example, an EUV excimer laser, or the like) using an exposure mask to expose the photoresist film with a pattern having a shape corresponding to the exposure mask. Then, the photoresist film after the exposure is developed. As a result, the metal-containing film MF having the opening OP may be formed. In addition, the opening OP may be formed by etching the metal-containing film MF.

Each of the films (the underlying film UF, the etching films EF1 and EF2, and the metal-containing film MF) constituting the substrate W may be formed by a CVD method, an ALD method, a spin coating method, or the like. Each of the above-described films may be a flat film or a film having unevenness.

At least a part of a process of forming each film of the substrate W may be performed in the space of the plasma processing chamber 10. For example, in a case where the metal-containing film MF is etched to form the opening OP, the step may be executed in the plasma processing chamber 10. In addition, the substrate may be prepared by forming all or a part of each film of the substrate W by an external device or a chamber of the plasma processing apparatus 1, and then carrying the substrate W into the plasma processing space 10s of the plasma processing apparatus 1, and disposing the substrate W in the center region 111a of the substrate support 11.

### (Step ST2: first etching step)

In the step ST2, the etching film EF1 is etched. The step ST2 may include a step of setting the pressure, a step of supplying the processing gas, and a step of generating plasma. Each step included in the step ST2 may be executed in parallel. In addition, the timing at which each of the steps is started may be optional. In one example, all of the steps may be started at the same time, or two or more steps may be started at different times.

### (Set of pressure)

In the step ST2, the pressure in the plasma processing chamber 10 is set. The pressure may be 1 mTorr or more and less than 100 mTorr. In addition, the pressure may be 100 mTorr or more and 5,000 mTorr or less. Hereinafter, the pressure in the range of 10 mTorr or more and less than 100 mTorr is also referred to as "low pressure". In addition, the pressure in a range of 100 mTorr or more and 1,000 mTorr or less is also referred to as "high pressure".

### (Supply of processing gas)

In the step ST2, the processing gas is supplied from the gas supply 20 into the plasma processing space 10s. The processing gas includes a halogen-containing gas. The halogen-containing gas may contain a halogen other than fluorine, and may contain a chlorine-containing gas and/or a bromine-containing gas. The processing gas may include a gas in which tin fluoride is not formed when the etching film EF1 is etched using the tin-containing film as a mask. As an example of the gas that does not generate tin fluoride, the halogen-containing gas included in the processing gas may be a gas that does not contain fluorine and/or hydrogen. The chlorine-containing gas may be a gas containing carbon. In one example, the chlorine-containing gas may be at least one selected from the group consisting of Cl₂, CₓCl_{y} (x and y are an integer 1 or more), and SiⱼClₖ (j and k are an integer of 1 or more). In addition, in one example, the bromine-containing gas may be BBr₃ and/or Br₂. The processing gas may or may not include a fluorine-containing gas. In one example, a flow rate of the halogen-containing gas supplied into the plasma processing chamber 10 may be 10 sccm or more and 3,000 sccm or less.

In the present processing method, the processing gas may include a halogen-containing gas other than the fluorine-containing gas. As a result, in the etching of the etching film EF1, it is possible to reduce the generation of a compound that is relatively stable and difficult to remove on the etching film EF1. In one example, the compound is a fluoride of a metal contained in the metal-containing film MF, such as tin fluoride. As a result, even in a case where the portion SC1 and/or SC2, which is the scum of the metal-containing film MF, is present inside the opening OP, the occurrence of defects in the etching film EF1 in the etching of the etching film EF1 is able to be reduced.

In the step ST2, the processing gas may include an inert gas. The inert gas may be a nitrogen gas (N₂) and/or a helium gas (He). In one example, the flow rate of the inert gas may be 10 sccm or more and 3,000 sccm or less. As described above, in the step ST2, the processing gas may include nitrogen gas (N₂) and/or helium gas (He). In this manner, the selectivity of the etching film EF1 with respect to the metal-containing film MF is able to be improved.

### (Supply of RF signal)

In the step ST2, plasma is generated in the plasma processing chamber 10. Specifically, when the source RF signal is supplied to the antenna 14, a highfrequency electric field is generated in the plasma processing space 10s, and plasma is generated from the processing gas. An effective value of the power of the source RF signal supplied to the antenna 14 may be 50 W or more and 5,000 W or less. When plasma is generated from the processing gas in the plasma processing space 10s, the etching film EF1 is etched by active species contained in the generated plasma, with the metal-containing film MF as a mask.

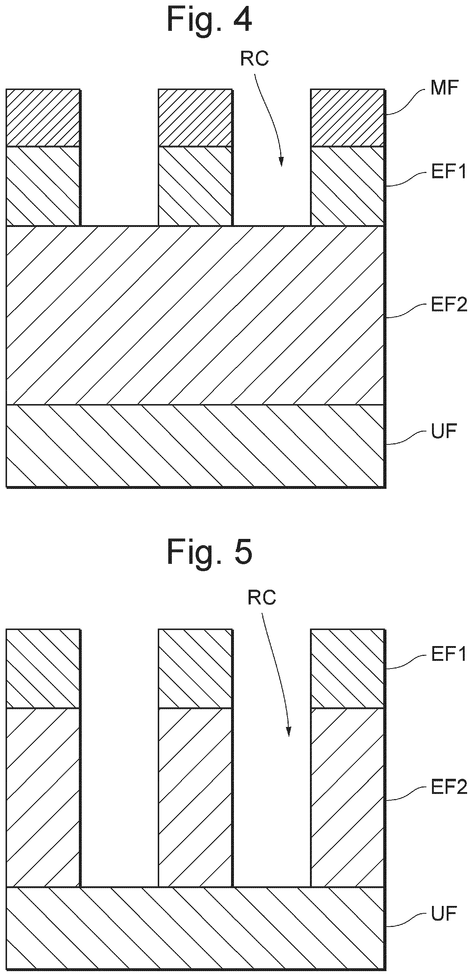

Fig. 4 is a view illustrating a cross-sectional structure of the substrate W after the etching film EF1 is etched in the step ST2. When the etching film EF1 is etched in the step ST2, as illustrated in Fig. 4, a recess portion RC is formed in the etching film EF1 (see Fig. 4). In addition, when the etching film EF1 is etched in the step ST2, a part of the metal-containing film MF may also be removed. As a result, as illustrated in Fig. 4, since the portions SC1 and SC2, which are a part of the metal-containing film MF, are removed, it is possible to reduce the occurrence of defects in the etching film EF1 in the etching of the etching film EF1.

For example, in a case where the metal-containing film MF includes a tin-containing film, the etching film EF1 includes a silicon-containing film, and the processing gas includes a chlorine-containing gas or a bromine-containing gas, in the etching of the etching film EF1, tin chloride or tin bromide is generated from the tin-containing film. Since tin chloride or tin bromide is, for example, less stable than tin fluoride, tin chloride or tin bromide is less likely to remain on the etching film EF1 than tin fluoride. Therefore, in a case where the processing gas includes a chlorine-containing gas or a bromine-containing gas, defects generated in the etching film EF1 are able to be further reduced. The processing gas may or may not include a fluorine-containing gas.

In the step ST2, a bias signal may be supplied to the substrate support 11. The bias signal may be a bias RF signal. The effective value of the power of the bias RF signal may be set based on the pressure in the plasma processing chamber 10. In a case where the pressure in the plasma processing chamber 10 is high, the effective value of the power of the bias RF signal may be 50 W or more and 5,000 W or less in one example. In addition, in a case where the pressure in the plasma processing chamber 10 is low, the effective value of the power of the bias RF signal may be 500 W or less, 200 W or less, or 100 W or less in one example.

### (Step ST3: second etching step)

In the step ST3, the etching film EF2 is etched. In the step ST3, the etching film EF2 is etched using the metal-containing film MF and/or the etching film EF1 as a mask. As an example, the etching film EF2 is a carbon-containing film.

In the step ST3, the processing gas is supplied from the gas supply 20 into the plasma processing space 10s. The processing gas may be selected such that the etching film EF2 is etched with a sufficient selectivity with respect to the metal-containing film MF and/or the etching film EF1. Then, the source RF signal is supplied to the antenna 14, and plasma is generated from the processing gas. In addition, the bias signal is supplied to the substrate support 11, and the bias potential is generated between the plasma and the substrate W. As a result, active species such as ions and radicals in the plasma are attracted to the substrate W, the etching film EF2 is etched by the active species, and the recess portion RC is formed in the etching film EF2 (see Fig. 5).

### <Examples>

Next, examples of the present processing method will be described. The present disclosure is not limited in any way by following examples.

### (Example 1)

In Example 1, the present processing method was applied to the substrate W using the plasma processing apparatus 1. The substrate W in Example 1 has a structure in which a SOC film (etching film EF2), a SiC film (etching film EF1), and a tin-containing photoresist film (metal-containing film MF) are stacked in this order (see Fig. 3). The opening OP is a line pattern. In the step ST2, the SiC film was etched under the following conditions.
Pressure: 500 mTorr
Processing gas: Cl₂, N₂
Source RF signal: 500 W
Bias RF signal: 900 W

### (Example 2)

In Example 2, the substrate W having the same structure as that of Example 1 was used. In addition, in the step ST2, the SiC film was etched under the following conditions.
Pressure: 20 mTorr
Processing gas: Cl₂, N₂, O₂
Source RF signal: 500 W
Bias RF signal: 300 W

### (Reference Example)

In Reference Example, the present processing method was applied to the substrate W using the plasma processing apparatus 1. The substrate W in Example 1 has a structure in which a SOC film (etching film EF2), a SOG film (etching film EF1), and a tin-containing photoresist film (metal-containing film MF) are stacked in this order (see Fig. 3). The opening OP is a line pattern. In the step ST2, the SOG film was etched under the following conditions.
Pressure: 30 mTorr
Processing gas: CF₄, CHF₃, N₂, Ar
Source RF signal: 300 W
Bias RF signal: 140 W

For Example 1, Example 2, and Reference Example, Table 1 illustrates the measurement results of the critical dimension (CD) and the line width roughness (LWR) after the processing of the step ST2. The LWR is the LWR of the metal-containing film MF after the processing of the step ST2. The CD1 is the CD of the metal-containing film MF after the processing of the step ST2. In addition, the CD2 is the CD of the bottom portion of the etching film EF1 after the processing of the step ST2.

**[Table 1]**

| | Reference Example | Example 1 | Example 2 |
|---|---|---|---|
| LWR [nm] | 4.02 | 1.92 | 2.73 |

As illustrated in Table 1, in any of Example 1 and Example 2, the LWR was improved as compared with the reference example. That is, in both Example 1 and Example 2, the portions SC1 and SC2 in the metal-containing film MF were reduced by the processing of the step ST2. In addition, in the reference example, the cross-sectional shape of the etching film EF1 was a tapered shape after the processing in the step ST2, whereas in Example 1 and Example 2, the cross-sectional shape of the etching film EF1 was a vertical shape.

The present processing method is able to be modified in various ways without departing from the scope and gist of the present disclosure. For example, the present processing method may be executed using a plasma processing apparatus using any plasma source such as a capacitively coupled plasma or a microwave plasma, in addition to the inductively coupled plasma processing apparatus 1.

The embodiments of the present disclosure further include the following aspects.

### (Addendum 1)

A plasma processing method including: a preparation step of preparing a substrate having a first etching film and a mask on the first etching film in a chamber, the mask including a metal-containing film; and
a first etching step of generating plasma in the chamber with a processing gas including one or both of a chlorine-containing gas and a bromine-containing gas to etch the first etching film.

### (Addendum 2)

The plasma processing method according to Addendum 1, in which the metal-containing film contains tin (Sn).

### (Addendum 3)

The plasma processing method according to Addendum 1 or 2, in which the first etching film is a silicon (Si)-containing film, a metal-containing film, or an organic film.

### (Addendum 4)

The plasma processing method according to Addendum 1 or 2, in which the first etching film is a silicon-containing film in which a ratio of the number of silicon atoms to the number of atoms other than silicon in the silicon-containing film is larger than a ratio of the number of silicon atoms to the number of atoms other than silicon in silicon oxide.

### (Addendum 5)

The plasma processing method according to Addendum 1 or 2, in which the first etching film includes at least one silicon-containing film selected from the group consisting of silicon carbide, amorphous silicon, and a silicon-containing antireflection film.

### (Addendum 6)

The plasma processing method according to any one of Addenda 1 to 5, in which the chlorine-containing gas and the bromine-containing gas do not contain hydrogen nor fluorine.

### (Addendum 7)

The plasma processing method according to any one of Addenda 1 to 6, in which the chlorine-containing gas contains carbon.

### (Addendum 8)

The plasma processing method according to Addendum 7, in which the first etching film includes a silicon oxide film.

### (Addendum 9)

The plasma processing method according to any one of Addenda 1 to 8, wherein the processing gas includes a chlorine-containing gas, and
the chlorine-containing gas includes at least one selected from the group consisting of Cl₂, CₓCl_{y} (x and y are an integer of 1 or more), and SiⱼClₖ (j and k are an integer of 1 or more).

### (Addendum 10)

The plasma processing method according to any one of Addenda 1 to 9, in which the processing gas includes an inert gas.

### (Addendum 11)

The plasma processing method according to Addendum 10, in which the inert gas includes a nitrogen gas (N₂) or a helium gas (He).

### (Addendum 12)

The plasma processing method according to any one of Addenda 1 to 11, in which the substrate includes a second etching film and the first etching film is disposed on the second etching film, and
the plasma processing method further includes a second etching step of etching the second etching film using at least the first etching film as a mask after the first etching step.

### (Addendum 13)

The plasma processing method according to any one of Addenda 1 to 12, in which the processing gas does not include an oxygen-containing gas.

### (Addendum 14)

The plasma processing method according to any one of Addenda 1 to 13, in which the first etching step includes setting a pressure in the chamber to 100 mTorr or more.

### (Addendum 15)

The plasma processing method according to Addendum 14, in which the preparation step includes disposing the substrate on a substrate support, and
the first etching step includes supplying a bias RF signal to the substrate support, an effective value of power of the bias RF signal being 100 W or more.

### (Addendum 16)

The plasma processing method according to any one of Addenda 1 to 13, in which the first etching step includes setting a pressure in the chamber to 100 mTorr or less.

### (Addendum 17)

The plasma processing method according to Addendum 16, in which the first etching step includes supplying a bias RF signal to the substrate support, and an effective value of power of the bias RF signal is 200 W or less.

### (Addendum 18)

A plasma processing method that is executed in a plasma processing apparatus including a chamber and a substrate support disposed in the chamber, the plasma processing method including:
a preparation step of preparing a substrate having a first etching film and a mask on the first etching film on the substrate support, the mask including a metal-containing film; and
a first etching step of plasma-etching the first etching film under a condition that tin fluoride is not formed on a surface of the mask.

### (Addendum 19)

A plasma processing apparatus including: a chamber; a substrate support that is disposed in the chamber; and a controller,
in which the controller executes:
preparing a substrate having a first etching film and a mask on the first etching film on the substrate support, in which the mask includes a metal-containing film, and
generating plasma in the chamber with a processing gas including one or both of a chlorine-containing gas and a bromine-containing gas to etch the first etching film.

## Claims

1. A plasma processing method comprising:
a preparation step of preparing a substrate having a first etching film and a mask on the first etching film in a chamber, the mask including a metal-containing film; and
a first etching step of generating plasma in the chamber with a processing gas including one or both of a chlorine-containing gas and a bromine-containing gas to etch the first etching film.

2. The plasma processing method according to claim 1, wherein the metal-containing film contains tin (Sn).

3. The plasma processing method according to claim 1, wherein the first etching film is a silicon (Si)-containing film, a metal-containing film, or an organic film.

4. The plasma processing method according to claim 1, wherein the first etching film is a silicon-containing film, wherein a ratio of the number of silicon atoms to the number of atoms other than silicon in the silicon-containing film is larger than a ratio of the number of silicon atoms to the number of atoms other than silicon in silicon oxide.

5. The plasma processing method according to claim 1, wherein the first etching film includes at least one silicon-containing film selected from the group consisting of silicon carbide, amorphous silicon, and a silicon-containing antireflection film.

6. The plasma processing method according to any one of claims 1 to 5, wherein the chlorine-containing gas and the bromine-containing gas do not contain hydrogen nor fluorine.

7. The plasma processing method according to any one of claims 1 to 5, wherein the chlorine-containing gas contains carbon.

8. The plasma processing method according to claim 6, wherein the first etching film includes a silicon oxide film.

9. The plasma processing method according to any one of claims 1 to 5, wherein the processing gas includes a chlorine-containing gas, and
the chlorine-containing gas includes at least one selected from the group consisting of Cl₂, CₓCl_{y} (x and y are an integer of 1 or more), and SiⱼClₖ (j and k are an integer of 1 or more).

10. The plasma processing method according to any one of claims 1 to 5, wherein the processing gas includes an inert gas.

11. The plasma processing method according to claim 10, wherein the inert gas includes a nitrogen gas (N₂) or a helium gas (He).

12. The plasma processing method according to any one of claims 1 to 5, wherein the substrate includes a second etching film and the first etching film is disposed on the second etching film, and
the plasma processing method further includes a second etching step of etching the second etching film using at least the first etching film as a mask after the first etching step.

13. The plasma processing method according to any one of claims 1 to 4, wherein the processing gas does not include an oxygen-containing gas.

14. The plasma processing method according to any one of claims 1 to 5, wherein the first etching step includes setting a pressure in the chamber to 100 mTorr or more.

15. The plasma processing method according to claim 14, wherein the preparation step includes disposing the substrate on a substrate support, and
the first etching step includes supplying a bias RF signal to the substrate support, an effective value of power of the bias RF signal being 100 W or more.

16. The plasma processing method according to any one of claims 1 to 5, wherein the first etching step includes setting a pressure in the chamber to 100 mTorr or less.

17. The plasma processing method according to claim 15, wherein the first etching step includes supplying a bias RF signal to the substrate support, an effective value of power of the bias RF signal being 200 W or less.

18. A plasma processing method that is executed in a plasma processing apparatus including a chamber and a substrate support disposed in the chamber, the plasma processing method comprising:
a preparation step of preparing a substrate having a first etching film and a mask on the first etching film on the substrate support, in which the mask includes a metal-containing film; and
a first etching step of plasma-etching the first etching film under a condition that tin fluoride is not formed on a surface of the mask.

19. A plasma processing apparatus comprising: a chamber; a substrate support that is disposed in the chamber; and a controller,
wherein the controller executes:
preparing a substrate having a first etching film and a mask on the first etching film on the substrate support, the mask including a metal-containing film, and
generating plasma in the chamber with a processing gas including one or both of a chlorine-containing gas and a bromine-containing gas to etch the first etching film.
